# EUROPÄISCHE PATENTSCHRIFT

(11) **EP 2 011 166 B1**
(45) Veröffentlichungstag und Bekanntmachung des Hinweises auf die Patenterteilung: **05.01.2011**
(21) Anmeldenummer: 07728434.7
(22) Anmeldetag: 24.04.2007
(51) Int. Cl.: H01L 41/04

(54) **PIEZOAKTOR MIT MEHRSCHICHT-VERKAPSELUNG UND VERFAHREN ZU SEINER HERSTELLUNG**
PIEZO ACTUATOR COMPRISING A MULTILAYER ENCAPSULATION, AND METHOD FOR THE PRODUCTION THEREOF
PIÉZO-ACTIONNEUR COMPORTANT UN ENCAPSULAGE MULTICOUCHE ET PROCÉDÉ DE FABRICATION

(30) Priorität: 26.04.2006 DE 102006019489
(43) Veröffentlichungstag der Anmeldung: 07.01.2009
(73) Patentinhaber: SIEMENS AKTIENGESELLSCHAFT, 80333 München (DE)
(72) Erfinder: BAYER, Heiner, 82140 Olching (DE); FREUDENBERG, Hellmut, 93080 Grossberg (DE); GANSTER, Axel, 84419 Schwindegg (DE); HAMANN, Christoph, 93107 Thalmassing (DE); HENNIG, Oliver, 81543 München (DE); JENSEN, Jens Dahl, 14050 Berlin (DE); LUGERT, Günter, 80804 München (DE); MOCK, Randolf, 85662 Hohenbrunn (DE); SCHUH, Carsten, 85598 Baldham (DE); ZAPF, Jörg, 81927 München (DE)
(86) Internationale Anmeldenummer: PCT/EP2007/053978
(87) Internationale Veröffentlichungsnummer: WO 2007/122227

(56) Entgegenhaltungen:
- EP-A- 0 603 588
- WO-A-01/48834
- WO-A-2007/093921
- WO-A-2007/102088
- DE-A1- 19 753 930
- JP-A- 1 137 686

## Beschreibung

### 1. Gebiet der Erfindung

Die vorliegende Erfindung betrifft ein Herstellungsverfahren einer Mehrschicht-Verkapselung eines Piezoaktors sowie einen Piezoaktor mit Mehrschicht-Verkapselung.

### 2. Hintergrund der Erfindung

In den letzten Jahren hat die Nachfrage nach piezokeramischen Aktoren oder kurz Piezoaktoren auf Grund ihrer zunehmenden Nutzung, beispielsweise in den neuesten Diesel-Einspritzsystemen der Automobilindustrie, enorm zugenommen. Diese Nachfrage unterstützt ebenfalls die Entwicklung von Piezoaktoren. In mehreren neuen Einspritz- bzw. Injektorkonstruktionen sollen die Piezoaktoren komplett von Dieselkraftstoff umgeben sein. Diese Art der Konstruktion der Einspritzanlagen bezeichnet man auch als "wet design".

Da die Piezoaktoren bei einem direkten Kontakt mit verunreinigtem oder durch Additive modifiziertem Dieselkraftstoff chemisch und elektrisch angegriffen werden, muss eine entsprechende Schutzhülle für den Piezoaktor bereitgestellt werden. Diese Schutzhülle sollte sowohl eine elektrische Isolation gegen einen möglichen Kurzschluss durch den elektrisch leitenden Kraftstoff als auch eine chemische Isolation gegen den Angriff des umgebenden Kraftstoffs auf die Bestandteile des Piezoaktors bereitstellen.

Im Stand der Technik sind Metallgehäuse unterschiedlicher Konstruktion bekannt, die den Piezoaktor umgeben. Ein Beispiel für ein derartiges Metallgehäuse ist ein Wellrohr. Die Metallgehäuse sind mit geeigneten Füllmaterialien gefüllt, um eine Übertragung des durch den Kraftstoff aufgebrachten Drucks auf den innen liegenden Piezoaktor zu realisieren. Diese konstruktive Lösung hat jedoch die Nachtteile, dass sie aufwendig in ihrer Herstellung und platzintensiv ist.

In JP 1-137686 A ist ein piezoelektrischer Stapelaktor mit einer Mehrschicht-Verkapselung aus alternierenden Polymerschichten und Metallschichten offenbart.

Es ist daher das Problem der vorliegenden Erfindung, einen Schutz für einen Piezoaktor bereitzustellen, der eine verlässliche elektrische und chemische Isolation des Piezoaktors gegen äußere Einflüsse gewährleistet.

### 3. Zusammenfassung der Erfindung

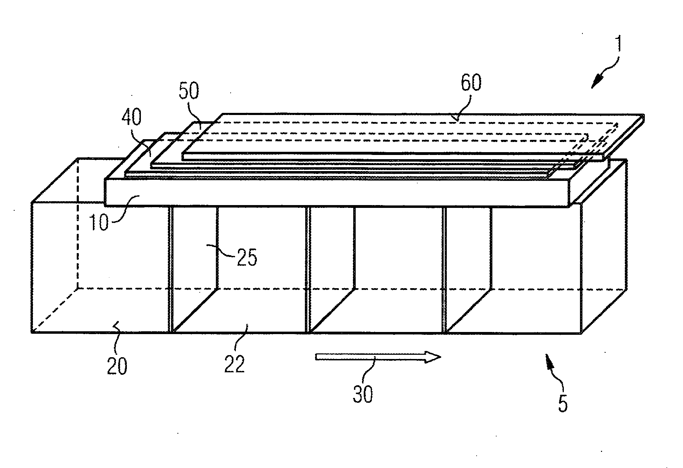

Das obige Problem wird durch ein Herstellungsverfahren einer Mehrschicht-Verkapselung eines Piezoaktors gemäß dem unabhängigen Patentanspruch 1 sowie durch einen Piezoaktor mit Mehrschicht-Verkapselung gemäß dem unabhängigen Patentanspruch 10 gelöst. Weiterentwicklungen und Vorteile der vorliegenden Erfindung gehen aus der folgenden Beschreibung, der Zeichnung und den anhängenden Patentansprüchen hervor.

Das obige Herstellungsverfahren der Mehrschicht-Verkapselung eines Piezoaktors, so dass der Piezoaktor ohne zusätzliche gehäuseartige umhüllende Struktur nach außen geschützt ist, umfasst die folgenden Schritte: a) Aufbringen einer elastischen Schicht auf eine Oberfläche des Piezoaktors, die parallel zu seiner Längs- oder Stapelrichtung verläuft, und b) Aufbringen einer metallischen Schicht auf die elastische Schicht, so dass diese die elastische Schicht flächig bedeckt.

Eine aufwendige feste gehäuseartige umhüllende Struktur des Piezoaktors wird dadurch ersetzt, dass der Piezoaktor zumindest an seinen Seitenflächen mit einer Multilayer-Struktur beschichtet wird. Diese Multilayer-Struktur besteht aus mindestens einer elastischen Schicht mit elastischen Materialeigenschaften und einer metallischen Schicht, die auf dieser elastischen Schicht aufgebracht ist. Die obige Multilayer-Struktur oder Mehrschicht-Verkapselung schließt den Piezoaktor vollständig ein oder ist auf dessen Seitenflächen paral-lel zu seiner Stapelrichtung beschränkt. Die Kombination aus elastischer und metallischer Schicht gewährleistet, dass der Piezoaktor beispielsweise in einem unter Hochdruck stehenden Kraftstoffreservoir mit ausreichender Mediendichtheit ausgestattet ist. Daher ist der chemisch aggressive Kraftstoff nicht in der Lage, den Piezoaktor anzugreifen. Des Weiteren gewährleistet die Mehrschicht-Verkapselung, dass der Piezoaktor trotz des umgebenden Kraftstoff-Hochdrucks in der Mehrschicht-Verkapselung ausreichend beweglich ist, um Stellvorgänge, von beispielsweise Kraftstoffventilen, vorzunehmen.

Gemäß einer Ausführungsform besteht die elastische Schicht vorzugsweise aus Silikonelastomer, Polyurethan, Polyimid oder Epoxid. Diese elastische Schicht wird gemäß einer weiteren Alternative des vorliegenden Herstellungsverfahrens durch geeignete Beschichtungsverfahren, wie beispielsweise Tauchen, Sprühen, Spritzen, Siebdruck oder Laminieren von Folien, aufgebracht.

Gemäß einer weiteren Ausführungsform wird die metallische Schicht als eine diffusionsdichte Metallschicht auf der elastischen Schicht erzeugt. Die metallische Schicht ist in ihrer Werkstoffwahl und Dimension an das umgebende Medium angepasst, so dass sie eine chemische Isolation gegen dieses Medium bereitstellt.

Um die metallische Schicht zu erzeugen, werden geeignete Beschichtungsverfahren zur Abscheidung von Metallen auf elektrisch nicht leitenden Oberflächen genutzt. Eine Alternative ist beispielsweise die Corona-Entladungsaktivierung mit aktivem Sauerstoff. Eine weitere Alternative besteht in der Erzeugung der metallischen Schicht durch physikalische Gasphasenabscheidung oder kurz ein PVD-Verfahren (physical vapor deposition). Gemäß einer weiteren Alternative ist es ebenfalls denkbar, zunächst eine für einen chemischen Schutz zu dünne metallische Schicht zu erzeugen, um diese in einem nachfolgenden Schritt durch ein galvanisches Beschichtungsverfahren zu verstärken.

Gemäß der Erfindung wird der bereits existierende Verbund aus elastischer und metallischer Schicht durch das Aufbringen einer weiteren elastischen Schicht auf die metallische Schicht und einer weiteren metallischen Schicht auf die elastische Schicht verstärkt. Neben der Verstärkung sind auf diese Weise ebenfalls die mechanischen Eigenschaften der Mehrschicht-Verkapselung des Piezoaktors gestaltbar, um einen optimalen Betrieb des Piezoaktors in dem jeweiligen umgebenden Medium zu gewährleisten. Daher werden die weitere elastische Schicht und die weitere metallische Schicht in Materialauswahl und Dicke derart angepasst, dass ein gradueller Eigenschaftsübergang vom Piezoaktor bis zur äußersten metallischen Schicht generierbar ist, der ein kompatibles Materialverhalten von Verkapselung und Piezoaktor gewährleistet. Gemäß einer weiteren Alternative erfolgt eine Abstimmung aller auf den Piezoaktor aufgebrachten Schichten der Mehrschicht-Verkapselung im Hinblick auf Materialeigenschaften und Dimension, um die Mehrschicht-Verkapselung im Hinblick auf ihre schützenden Eigenschaften und die Unterstützung des Betriebs des Piezoaktors zu optimieren. Es ist des Weiteren denkbar, mehr als die bereits oben genannten vier Schichten aufzubringen.

Die vorliegende Erfindung offenbart des Weiteren einen Piezoaktor mit Mehrschicht-Verkapselung, so dass der Piezoaktor ohne zusätzliche gehäuseartige umhüllende Struktur nach außen geschützt ist. Der Piezoaktor mit Mehrschicht-Verkapselung weist eine elastische Schicht auf einer Oberfläche des Piezoaktors auf, die parallel zu seiner Längs- oder Stapelrichtung verläuft, sowie eine metallische Schicht auf der elastischen Schicht, die die elastische Schicht vollflächig bedeckt.

### 4. Kurze Beschreibung der begleitenden Zeichnung

Die bevorzugten Ausführungsformen der vorliegenden Erfindung werden unter Bezugnahme auf die begleitende Zeichnung näher erläutert. Diese zeigt eine schematische Schnittdarstellung eines Piezoaktors im Schnitt, der eine bevorzugte Ausführungsform einer Mehrschicht-Verkapselung an einer seiner Seitenflächen aufweist.

### 5. Detaillierte Beschreibung bevorzugter Ausführungsformen

Um die hohen Anforderungen an eine Schutzhülle eines Piezoaktors 5 unter Kraftstoff-Hochdruck oder aufgrund der Belastung durch ein anderes umgebendes Medium zu gewährleisten, wird der Piezoaktor 5 mit einer Mehrschicht-Verkapselung 1 ausgestattet. Diese Mehrschicht-Verkapselung 1 lässt sich mit dem im Folgenden beschriebenen Herstellungsverfahren aufbringen, so dass man einen Piezoaktor 5 mit Mehrschicht-Verkapselung 1 erhält.

Die obigen Anforderungen an die Mehrschicht-Verkapselung 1 schließen eine Mediendichtheit sowie eine chemische und elektrische Isolation des Piezoaktors 5 nach außen ein. Dadurch wird sichergestellt, dass kein Angriff des umgebenden Mediums den Piezoaktor 5 beschädigt, zerstört oder seine Lebensdauer verringert. Als eine weitere Anforderung wird durch die Mehrschicht-Verkapselung 1 eine hohe Elastizität an der Grenzfläche zwischen Piezoaktor 5 und Mehrschicht-Verkapselung 1 bereitgestellt. Durch die hohe Elastizität an dieser Grenzfläche schränkt die Mehrschicht-Verkapselung 1 den Betrieb des Piezoaktors 5 nicht ein, so dass annähernd der vollständige Stellweg des Piezoaktors 5 für beliebige Stellvorgänge zur Verfügung steht.

Um die obigen Anforderungen zu erfüllen, wird die Mehrschicht-Verkapselung 1 in Form einer Multilayer-Struktur auf den Piezoaktor 5 aufgebracht. Gemäß einer ersten Alternative wird die Mehrschicht-Verkapselung auf die gesamte äußere Oberfläche des Piezoaktors 5 aufgebracht. Gemäß einer weiteren Alternative bedeckt die Mehrschicht-Verkapselung 1 nur die parallel zur Stapelrichtung 30 verlaufenden seitlichen Oberflächen des Piezoaktors 5. In letzterem Fall sind die Stirnseiten des Piezoaktors 5 senkrecht zur Stapelrichtung 30 ausreichend durch ihre eigene Materialbeschaffenheit oder durch andere Strukturen/Konstruktionen geschützt.

Die Mehrschicht-Verkapselung 1 weist zunächst eine elektrisch isolierende elastische Schicht 10 auf. Diese Schicht 10 wird direkt auf die Oberfläche des Piezoaktors 5 aufgebracht und besteht beispielsweise aus Kunststoff. Diese elektrisch isolierende elastische Schicht 10 hat die Aufgabe, die mechanische Dehnung des Piezoaktors 5 nach außen hin abzubauen. Dadurch soll im Speziellen verhindert werden, dass sich die mechanischen Dehnungen des Piezoaktors 5, insbesondere auch im Bereich von möglichen Polungsrissen, derart auf die unten beschriebene metallische Schicht 40 übertragen, dass diese beschädigt wird. Daher gewährleistet die elektrisch isolierende elastische Schicht 10, dass auch im dynamischen Dauerbetrieb des Piezoaktors 5 die metallische Schicht 40 ohne Beschädigungen erhalten bleibt.

Eine weitere Aufgabe der elektrisch isolierenden elastischen Schicht 10 besteht in einer Isolation der Oberfläche des Piezoaktors 5. Diese Isolation erfolgt gegen sämtliche äußere Medien, so dass weder das Material der elastischen Schicht 10 noch irgendein anderes Medium in Poren, Oberflächen-, Polungsrisse oder mögliche Delaminationen zwischen Innenelektroden 25 und piezoelektrischer Schicht 20 eindringen kann.

Die elektrisch isolierende elastische Schicht 10 besteht gemäß verschiedener Ausführungsformen aus Silikonelastomer, Polyurethan, Polyimid oder Epoxid.

Die elastische Schicht 10 wird durch geeignete Beschichtungsverfahren auf dem Piezoaktor 5 aufgebracht, mit denen sich elektrisch isolierende elastische Schichten 10 ausreichender Dicke auf Oberflächen erzeugen lassen. Verschiedene Alternativen eines derartigen Beschichtungsverfahrens sind Tauchen, Sprühen, Spritzen, Siebdruck oder Laminieren von Folien.

Die Mehrschicht-Verkapselung 1 weist des Weiteren eine metallische Schicht 40 auf, die auf die elastische Schicht 10 aufgebracht worden ist. Die metallische Schicht wird vorzugsweise als diffusionsdichte Metallschicht erzeugt. Als mögliche Materialien dienen übliche Metalle, die durch Beschichtungsverfahren verarbeitbar sind. Dies sind beispielsweise Kupfer oder Nickel.

Die metallische Schicht 40 hat die Funktion, nach außen hin eine chemische Isolation des Piezoaktors 5 mit Mehrschicht-Verkapselung 1 bereitzustellen. Diese chemische Isolation verhindert vor allem den chemischen Angriff eines umgebenden aggressiven Mediums, wie beispielsweise Dieselkraftstoff.

Die metallische Schicht 40 kann durch alle geeigneten Verfahren aufgebracht werden, mit denen Metallschichten auf elektrisch nicht leitenden Oberflächen generierbar sind. Gemäß einer ersten Alternative wird die Metallschicht 40 durch eine chemische Direktmetallisierung erzeugt, wie sie in der WO 2005/087979 beschrieben ist. Hier erfolgt durch eine hoch aktive Corona-Entladungsaktivierung mit aktiven SauerstoffIonen die Erzeugung einer Metallschicht auf Silikonelastomeren.

Gemäß einer weiteren Alternative wird auf der elastischen Schicht 10 zunächst nur eine metallische Dünnschicht mittels physikalischer Gasphasenabscheidung bzw. PVD-Verfahren aufgebracht. Nachfolgend wird diese metallische Dünnschicht durch bekannte galvanische Verfahren verstärkt, so dass sie eine ausreichende chemische Isolation bereitstellt. Bei den oben genannten PVD-Verfahren liegt das als metallische Schicht 40 abzuscheidende Material in fester Form in einer Beschichtungskammer vor. Mit Hilfe von Verdampfen, Ionenbeschuss, E-lektronenbeschuss, Strom- oder Laserbeschuss wird das spätere Schichtmaterial auf die zu beschichtenden Teile aufgebracht und bildet dort die gewünschte metallische Schicht 40. Bei den oben genannten galvanischen Beschichtungsverfahren werden metallische Ionen aus einer Elektrolytlösung als metallische Schicht bzw. Verstärkung auf der bereits existierenden metallischen Dünnschicht abgeschieden.

Um die bestmögliche Mediendichtheit, chemische und elektrische Isolation sowie Dehnungsfähigkeit der Mehrschicht-Verkapselung 1 zu realisieren und dadurch einen optimalen Betrieb des Piezoaktors 5 zu gewährleisten, werden erfindungsgemäß jeweils eine weitere elastische Schicht 50 und eine weitere metallische Schicht 60 auf die bereits existierenden Schichten 10, 40 aufgebracht. Es ist des Weiteren bevorzugt, eine Mehrzahl von weiteren elastischen und weiteren metallischen Schichten 50, 60 in abwechselnder Anordnung auf die bereits existierende Mehrschicht-Verkapselung 1 aufzubringen. Die Mehrschicht-Verkapselung 1 bestehend aus mehreren elastischen Schichten 10, 50 und mehreren metallischen Schichten 40, 60 gewährleisten einen graduellen Eigenschaftsübergang vom Piezoaktor 5 bis zur äußersten metallischen Schicht 60 der Mehrschicht-Verkapselung 1. Auf diese Weise wird die äußerste metallische Schicht der Mehrschicht-Verkapselung 1 nicht durch das Dehnungsverhalten des Piezoaktors 5 beschädigt oder zerstört. Des Weiteren ist aber auch sichergestellt, dass der Piezoaktor 5 von außen beispielsweise nicht durch zu hohe Temperaturen belastet wird.

Für einen dauerhaften Betrieb von Piezoaktor 5 mit Mehrschicht-Verkapselung 1 ist es des Weiteren erforderlich, dass die verwendeten Materialien eine ausreichende Temperatur- und Langzeitstabilität aufweisen. Ein beispielgebender Temperaturbereich für den Piezoaktor 5 mit Mehrschicht-Verkapselung 1 liegt zwischen -40°C und 180°C. Des Weiteren müssen die verwendeten Materialien so dauerhaft sein, dass sie für die Lebensdauer des Piezoaktors 5 erhalten bleiben. Ein Beispiel für diese Lebensdauer wären ca. 10 Jahre. Es ist zudem zu beachten, dass einige Metalle, wie beispielsweise Kupfer, von Kraftstoffen oder anderen Medien angegriffen werden. Diese sollten daher nur als eine metallische Zwischenschicht 40 eingesetzt werden.

Im Vergleich zu bisher genutzten Verkapselungsmethoden für Piezoaktoren 5 bietet die oben beschriebene Konstruktion eine kompaktere Bauweise, eine minimale Dämpfung des Piezoaktors 5 während seines Betriebs sowie ein einfacheres Design ohne Bedarf eines Druckübertragungsmediums zwischen Piezoaktor 5 und der äußeren metallischen Schicht der Mehrschicht-Verkapselung 1. Ein weiterer Vorteil besteht darin, dass die Mehrschicht-Verkapselung 1 als eine Komplettlösung innerhalb eines Beschichtungsverfahrens realisierbar ist, so dass Arbeitsaufwand und Kosten für dieses Herstellungsverfahren geringer ausfallen im Vergleich zum Stand der Technik.

## Patentansprüche

1. Herstellungsverfahren einer Mehrschicht-Verkapselung (1) eines Piezoaktors (5), so dass der Piezoaktor (5) ohne zusätzliche feste gehäuseartige umhüllende Struktur nach außen geschützt ist, das die folgenden Schritte aufweist:
a. Aufbringen einer elektrisch isolierenden elastischen Schicht (10) auf eine Oberfläche (20) des Piezoaktors (5), die parallel zu seiner Längs- oder Stapelrichtung (30) verläuft,
b. Aufbringen einer metallischen Schicht (40) auf die elastische Schicht (10), so dass diese die elektrisch isolierende elastische Schicht (10) flächig bedeckt,
c. Aufbringen einer weiteren elektrisch isolierenden elastischen Schicht (50) auf die metallische Schicht (40) und
d. Aufbringen einer weiteren metallischen Schicht (60) auf die weitere elektrisch isolierende elastische Schicht (50), wobei
die elektrisch isolierende Schicht (10), die weitere elektrisch isolierende elastische Schicht (50) und die weitere metallische Schicht (60) in Materialauswahl und Dicke derart angepasst werden, dass ein gradueller Eigenschaftsübergang vom Piezoaktor zur weiteren metallischen Schicht (60) generiert wird, der ein kompatibles Materialverhalten von Verkapselung und Piezoaktor gewährleistet.

2. Herstellungsverfahren gemäß Anspruch 1, in dem die elektrisch isolierende elastische Schicht (10) eine Kunststoffschicht, vorzugsweise Polymerschicht, ist.

3. Herstellungsverfahren gemäß einem der vorhergehenden Ansprüche, in dem die elektrisch isolierende elastische Schicht (10) aus Silikonelastomer, Polyurethan, Polyimid oder Epoxid besteht.

4. Herstellungsverfahren gemäß einem der vorhergehenden Ansprüche, mit dem weiteren Schritt:
Aufbringen der elektrisch isolierenden elastischen Schicht (10) durch geeignete Beschichtungsverfahren, vorzugsweise mittels Tauchen, Sprühen, Spritzen, Siebdruck oder Laminieren von Folien.

5. Herstellungsverfahren gemäß einem der vorhergehenden Ansprüche, mit dem weiteren Schritt:
Erzeugen der metallischen Schicht (40) als diffusionsdichte Metallschicht.

6. Herstellungsverfahren gemäß einem der vorhergehenden Ansprüche, mit dem weiteren Schritt:
Herstellen der metallischen Schicht (40) mit geeigneten Beschichtungsverfahren zur Abscheidung von Metallen auf elektrisch nicht leitenden Oberflächen.

7. Herstellungsverfahren gemäß einem der vorhergehenden Ansprüche, in dem die metallische Schicht mittels chemischer Direktmetallisierung hergestellt wird.

8. Herstellungsverfahren gemäß einem der vorhergehenden Ansprüche, 1 bis 6, in dem die metallische Schicht (40) mittels physikalischer Gasphasenabscheidung (PVD-Verfahren) hergestellt wird.

9. Herstellungsverfahren gemäß Anspruch 8, mit dem weiteren Schritt:
Verstärken der metallischen Schicht (40) durch ein galvanisches Beschichtungsverfahren.

10. Piezoaktor (5) mit Mehrschicht-Verkapselung (1), insbesondere ein Vielschichtaktor, so dass der Piezoaktor (5) ohne zusätzliche feste gehäuseartige umhüllende Struktur nach außen geschützt ist, der die folgenden Merkmale aufweist:
a. einen Piezoaktors (5),
b. eine elektrisch isolierende elastische Schicht (10) auf einer Oberfläche (20) des Piezoaktors (5), die parallel zu seiner Längs- oder Stapelrichtung (30) verläuft,
c. eine metallische Schicht (40) auf der elektrisch isolierenden elastischen Schicht (10), die die elektrisch isolierende elastische Schicht (10) flächig bedeckt,
d. eine weitere elektrisch isolierende elastische Schicht (50) auf der metallischen Schicht (40) und
e. eine weitere metallische Schicht (60) auf der weiteren elektrisch isolierenden elastischen Schicht (50), wobei die elektrisch isolierende Schicht (10), die weitere elektrisch isolierende elastische Schicht (50) und die weitere metallische Schicht (60) in Materialauswahl und Dicke derart angepasst sind, dass ein gradueller Eigenschaftsübergang vom Piezoaktor zur weiteren metallischen Schicht (60) vorhanden ist, der ein kompatibles Materialverhalten von Verkapselung und Piezoaktor gewährleistet.

## Claims

1. Production method for a multilayer encapsulation (1) of a piezo actuator (5), such that the piezo actuator (5) is externally protected without an additional solid casing-like enveloping structure, which method comprises the following steps:
a. depositing an electrically insulating elastic layer (10) onto a surface (20) of the piezo actuator (5), said surface running parallel with the longitudinal or stacking direction (30) of the piezo actuator,
b. depositing a metallic layer (40) onto the elastic layer (10), such that the metallic layer covers the electrically insulating elastic layer (10) in a planar manner,
c. depositing a further electrically insulating elastic layer (50) onto the metallic layer (40), and
d. depositing a further metallic layer (60) onto the further electrically insulating elastic layer (50), wherein the electrically insulating layer (10), the further electrically insulating elastic layer (50) and the further metallic layer (60) are adapted in terms of material and thickness, such that a gradual property transition from the piezo actuator to the further metallic layer (60) is created, thereby ensuring compatible material behaviour of encapsulation and piezo actuator.

2. Production method according to claim 1, in which the electrically insulating elastic layer (10) is a plastic layer, preferably a polymer layer.

3. Production method according to one of the preceding claims, in which the electrically insulating elastic layer (10) consists of silicone elastomer, polyurethane, polyimide or epoxide.

4. Production method according to one of the preceding claims, comprising the further step:
depositing the electrically insulating elastic layer (10) by means of suitable coating methods, preferably by means of dipping, spraying, injecting, screen printing or lamination of films.

5. Production method according to one of the preceding claims, comprising the further step:
generating the metallic layer (40) as a diffusion-proof metal layer.

6. Production method according to one of the preceding claims, comprising the further step:
creating the metallic layer (40) by means of suitable coating methods for deposition of metals onto surfaces which are not electrically conductive.

7. Production method according to one of the preceding claims, in which the metallic layer is created by means of chemical direct metallization.

8. Production method according to one of the preceding claims 1 to 6, in which the metallic layer (40) is created by means of a physical vapour deposition method (PVD).

9. Production method according to claim 8, comprising the further step:
reinforcing the metallic layer (40) by means of an electroplating coating method.

10. Piezo actuator (5) with multilayer encapsulation (1), in particular a multilayer actuator, such that the piezo actuator (5) is externally protected without an additional solid casing-type enveloping structure, having the following features:
a. a piezo actuator (5),
b. an electrically insulating elastic layer (10) on a surface (20) of the piezo actuator (5), said surface running parallel with the longitudinal or stacking direction (30) of the piezo actuator,
c. a metallic layer (40) on the electrically insulating elastic layer (10), said metallic layer covering the electrically insulating elastic layer (10) in a planar manner,
d. a further electrically insulating elastic layer (50) on the metallic layer (40), and
e. a further metallic layer (60) on the further electrically insulating elastic layer (50), wherein
the electrically insulating layer (10), the further electrically insulating elastic layer (50) and the further metallic layer (60) are adapted in terms of material and thickness, such that a gradual property transition from the piezo actuator to the further metallic layer (60) is created, thereby ensuring compatible material behaviour of encapsulation and piezo actuator

## Revendications

1. Procédé de fabrication d'un encapsulage multicouche (1) d'un actionneur piézoélectrique (5), de sorte que l'actionneur piézoélectrique (5) est protégé vers l'extérieur sans structure enveloppante de type boîtier, rigide et supplémentaire, qui présente les étapes suivantes :
a. application d'une couche (10) élastique électro-isolante sur une surface (20) de l'actionneur piézoélectrique (5), qui est agencée parallèlement à sa direction longitudinale ou sa direction d'empilement (30),
b. application d'une couche (40) métallique sur la couche (10) élastique, de sorte que celle-ci recouvre en surface la couche (10) élastique électro-isolante,
c. application d'une autre couche (50) élastique électro-isolante sur la couche (40) métallique, et
d. application d'une autre couche (60) métallique sur l'autre couche (50) élastique électro-isolante,
la couche (10) électro-isolante, l'autre couche (50) élastique électro-isolante et l'autre couche métallique (60) étant adaptées dans le choix du matériau et l'épaisseur de telle sorte qu'un transfert de propriété graduel de l'actionneur piézoélectrique à l'autre couche (60) métallique est généré, lequel garantit un comportement de matériau compatible de l'encapsulage et de l'actionneur piézoélectrique.

2. Procédé de fabrication selon la revendication 1, dans lequel la couche (10) élastique électro-isolante est une couche plastique, de préférence une couche polymère.

3. Procédé de fabrication selon l'une quelconque des revendications précédentes, dans lequel la couche (10) élastique électro-isolante est à base d'élastomère de silicone, de polyuréthane, polyimide ou résine d'époxy.

4. Procédé de fabrication selon l'une quelconque des revendications précédentes, comprenant l'étape supplémentaire:
application de la couche (10) élastique électro-isolante par des procédés de revêtement appropriés, de préférence au moyen d'immersion, pulvérisation, injection, sérigraphie ou laminage de feuilles.

5. Procédé de fabrication selon l'une quelconque des revendications précédentes, comprenant l'étape supplémentaire:
génération de la couche (40) métallique comme couche métallique étanche à la diffusion.

6. Procédé de fabrication selon l'une quelconque des revendications précédentes, comprenant l'étape supplémentaire:
fabrication de la couche (40) métallique avec des procédés de revêtement appropriés pour le dépôt de métaux sur des surfaces non électro-conductrices.

7. Procédé de fabrication selon l'une quelconque des revendications précédentes, dans lequel la couche métallique est fabriquée au moyen de métallisation directe chimique.

8. Procédé de fabrication selon l'une quelconque des revendications précédentes 1 à 6, dans lequel la couche (40) métallique est fabriquée au moyen de dépôt en phase gazeuse par procédé physique (procédé PVD).

9. Procédé de fabrication selon la revendication 8, comprenant l'étape supplémentaire:
renforcement de la couche (40) métallique par un procédé de revêtement galvanique.

10. Actionneur piézoélectrique (5) avec encapsulage multicouche (1), en particulier un actionneur multicouche, de sorte que l'actionneur piézoélectrique (5) est protégé vers l'extérieur sans structure enveloppante, de type boîtier, rigide, supplémentaire, qui présente les caractéristiques suivantes :
a. un actionneur piézoélectrique (5),
b. une couche (10) élastique électro-isolante sur une surface (20) de l'actionneur piézoélectrique (5), qui est agencée parallèlement à sa direction longitudinale ou sa direction d'empilement (30),
c. une couche (40) métallique sur la couche (10) élastique électro-isolante qui recouvre en surface la couche (10) élastique électro-isolante,
d. une autre couche (50) élastique électro-isolante sur la couche (40) métallique, et
e. une autre couche (60) métallique sur l'autre couche (50) élastique électro-isolante,
la couche (10) électro-isolante, l'autre couche (50) élastique électro-isolante et l'autre couche (60) métallique étant adaptées dans le choix du matériau et l'épaisseur de telle sorte qu'un transfert de propriété graduel de l'actionneur piézoélectrique à l'autre couche (60) métallique est présent, lequel garantit un comportement de matériau compatible de l'encapsulage et de l'actionneur piézoélectrique.
